# EUROPEAN PATENT APPLICATION

(11) **EP 4 564 679 A1**
(43) Date of publication of application: **04.06.2025**
(21) Application number: 24215542.2
(22) Date of filing: 26.11.2024
(51) Int. Cl.: H03K 17/687, H03K 17/693, H03K 17/10, H03H 11/24

(54) **SWITCH CIRCUITS, ATTENUATION CIRCUITS, RECEIVERS, BASE STATION AND MOBILE DEVICE**

(30) Priority: 28.11.2023 US 202318520608
(71) Applicant: Intel Corporation, Santa Clara, CA 95054 (US)
(72) Inventor: CASCIO, Giacomo, 9500 Villach (AT); CLARA, Martin, Santa Clara, 95050 (US); GHADERI, Erfan, Hillsboro, 97123 (US); TIEBOUT, Marc Jan Georges, 9584 Finkenstein (AT)
(74) Representative: 2SPL Patentanwälte PartG mbB

(57) **Abstract**

A switch circuit is provided. The switch circuit includes a first node for coupling to a first conductive path and a second node for coupling to a second conductive path. Additionally, the switch circuit includes first and second stacks of transistors arranged between the first and second nodes. A first transistor of the first stack and a first transistor of the second stack are respectively cross-coupled with a second transistor of the second stack and a second transistor of the first stack. The first transistors of the first and the second stack are coupled to the first node. A third transistor of the first stack and a third transistor of the second stack are respectively cross-coupled with a fourth transistor of the second stack and a fourth transistor of the first stack. The fourth transistors of the first and the second stack are coupled to the second node.

## Description

### Field

The present disclosure relates to transistor-based switches. In particular, examples of the present disclosure relate to switch circuits, attenuation circuits, receivers, a base station and a mobile device.

### Background

In modern high-speed and multi-Gigabit wireless communication systems and applications (such as 5G or 6G), there is a growing interest and demand for integrated circuits operating at high frequency and with the ability to control signal strength and phase uniformly, implementing automatic gain-control functions.

For example, a signal swing received by a 5G base station might significantly exceed the supply and ground voltages because of a high-power blocker or overload condition in crowded areas. This condition can happen several times during product lifetime. A Radio Frequency (RF) transceiver of the base station must tolerate - without damage - those transient events with unknown (only probabilistic) duration.

Gain controlling circuits such as Digital Step Attenuators (DSAs) with power handling capability are desired to be co-integrated with all the RF blocks into a single transceiver chip. Low power consumption is a target for the DSA since the systems consist of many transmit/receive chains integrated with the respective antenna elements, including the automatic gain control of transmitter and receiver systems.

Designing an RF transceiver design with embedded DSA in leading-edge technologies becomes very challenging when overvoltage and undervoltage tolerances significantly exceed technology limits of the safe operating area of the devices. As transistor gate oxide scaling decreases with advancing semiconductor technology nodes, the device breakdown voltage and consequently the overvoltage tolerance of RF I/O pads at the semiconductor chip is becoming more and more problematic. Devices in modern semiconductor technology nodes are very sensitive to voltage stress (typically < 1 V), with the effect of severe reliability problems if devices are exposed to excessive over-/undervoltage. This leads to performance degradation over lifetime or - in the worst-case scenario - early field failures with product returns.

Hence, there may be a demand to overcome the above limitations.

### Brief description of the Figures

Some examples of apparatuses and/or methods will be described in the following by way of example only, and with reference to the accompanying figures, in which
Fig. 1 illustrates a first example of a switch circuit;
Fig. 2 illustrates a second example of a switch circuit;
Fig. 3 illustrates a third example of a switch circuit;
Fig. 4 illustrates a first exemplary control circuitry;
Fig. 5 illustrates a second exemplary control circuitry;
Fig. 6 illustrates a first exemplary receiver with an attenuation circuit;
Fig. 7 illustrates a second exemplary receiver with an attenuation circuit;
Fig. 8 illustrates a comparison of linearities for different attenuation circuits;
Fig. 9 illustrates an example of a base station; and
Fig. 10 illustrates an example of a mobile device.

### Detailed Description

Some examples are now described in more detail with reference to the enclosed figures. However, other possible examples are not limited to the features of these embodiments described in detail. Other examples may include modifications of the features as well as equivalents and alternatives to the features. Furthermore, the terminology used herein to describe certain examples should not be restrictive of further possible examples.

Throughout the description of the figures same or similar reference numerals refer to same or similar elements and/or features, which may be identical or implemented in a modified form while providing the same or a similar function. The thickness of lines, layers and/or areas in the figures may also be exaggerated for clarification.

When two elements A and B are combined using an "or", this is to be understood as disclosing all possible combinations, i.e. only A, only B as well as A and B, unless expressly defined otherwise in the individual case. As an alternative wording for the same combinations, "at least one of A and B" or "A and/or B" may be used. This applies equivalently to combinations of more than two elements.

If a singular form, such as "a", "an" and "the" is used and the use of only a single element is not defined as mandatory either explicitly or implicitly, further examples may also use several elements to implement the same function. If a function is described below as implemented using multiple elements, further examples may implement the same function using a single element or a single processing entity. It is further understood that the terms "include", "including", "comprise" and/or "comprising", when used, describe the presence of the specified features, integers, steps, operations, processes, elements, components and/or a group thereof, but do not exclude the presence or addition of one or more other features, integers, steps, operations, processes, elements, components and/or a group thereof.

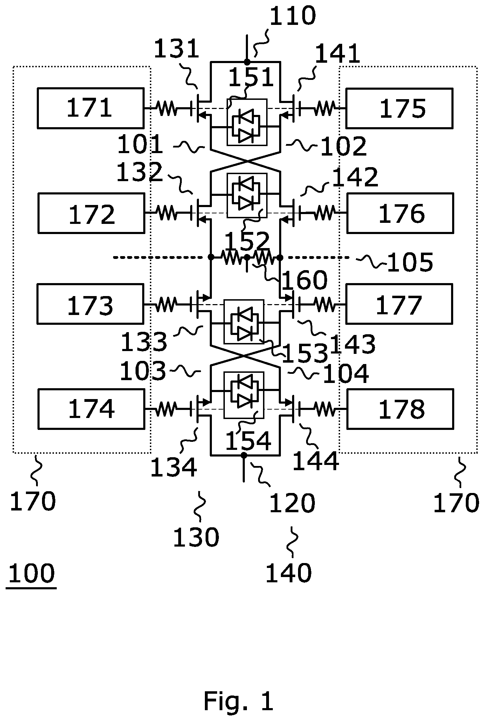

**Fig. 1** illustrates an exemplary switch circuit 100. The switch circuit 100 comprises a first node 110 for coupling to a first conductive path and a second node 120 for coupling to a second conductive path. For example, the first conductive path and the second conductive path may be signal paths (lines, traces) of a differential circuit such as an attenuator (e.g., a DSA).

The switch circuit 100 comprises a first stack of transistors 130 arranged between the first node 110 and the second node 120. Additionally, the switch circuit 100 comprises a second stack of transistors 140 arranged between the first node 110 and the second node 120. That is, the first node 110 is arranged above the first stack 130 and the second stack 140, whereas the second node 120 arranged below the first stack 130 and the second stack 140. The first stack 130 comprises the four transistors 131, 132, 133 and 134 vertically stacked on top of each other. The second stack 140 comprises the four transistors 141, 142, 143 and 144 vertically stacked on top of each other. The first stack 130 is arranged left of the second stack 140. In other words, the first stack 130 and the second stack 140 are arranged laterally offset from each other.

In the example of Fig. 1, the transistors 131, 132, 143 and 144 are p-type transistors (being an example for transistors of a first conductivity type) and the transistors 141, 142, 133 and 134 are n-type transistors (being an example for transistors of a second conductivity type). However, it is to be noted that the present disclosure is not limited thereto. In other examples, the transistors 131, 132, 143 and 144 may be n-type transistors and the transistors 141, 142, 133 and 134 may be p-type transistors. In general, the transistors 131, 132, 143 and 144 are of a first conductivity type and the transistors 141, 142, 133 and 134 are of a second conductivity type different from the first conductivity type.

The drain (terminal) of the transistor 131, which may be referred to as the "first transistor of the first stack" in the present disclosure, is coupled to the first node 110. The source (terminal) of the transistor 132, which may be referred to as the "second transistor of the first stack" in the present disclosure, is coupled to the source (terminal) of the transistor 133, which may be referred to as the "third transistor of the first stack" in the present disclosure. The drain (terminal) of the transistor 134, which may be referred to as the "fourth transistor of the first stack" in the present disclosure, is coupled to the second node 120.

Similarly, the drain (terminal) of the transistor 141, which may be referred to as the "first transistor of the second stack" in the present disclosure, is coupled to the first node 110. The source (terminal) of the transistor 142, which may be referred to as the "second transistor of the second stack" in the present disclosure, is coupled o the source (terminal) of the transistor 143, which may be referred to as the "third transistor of the first stack" in the present disclosure. The drain (terminal) of the transistor 144, which may be referred to as the "fourth transistor of the second stack" in the present disclosure, is coupled to the second node 120.

The source (terminal) of the transistor 131 is coupled to the drain (terminal) of the transistor 142. The source (terminal) of the transistor 141 is coupled to the drain (terminal) of the transistor 132. Accordingly, a first conductive trace (path) 101 coupling (the source of) the transistor 131 and (the drain of) the transistor 142 crosses a second conductive trace (path) 102 coupling (the source of) the transistor 141 and (the drain of) the transistor 132. That is, the first transistor of the first stack 130 is cross-coupled with the second transistor of the second stack 140 and the first transistor of the second stack 140 is cross-coupled with the second transistor of the first stack 130. In other words, the first stack 130 and the second stack 140 are cross-coupled via the coupling between (the source of) the transistor 131 and (the drain of) the transistor 142 as well as the coupling between (the source of) the transistor 141 and (the drain of) the transistor 132.

The source (terminal) of the transistor 134 is coupled to the drain (terminal) of the transistor 143. The source (terminal) of the transistor 144 is coupled to the drain (terminal) of the transistor 133. Accordingly, a third conductive trace 103 coupling (the source of) the transistor 134 and (the drain of) the transistor 143 crosses a fourth conductive trace 104 coupling (the source of) the transistor 144 and (the drain of) the transistor 133. That is, the third transistor of the first stack 130 is cross-coupled with the fourth transistor of the second stack 140 and the third transistor of the second stack 140 is cross-coupled with the fourth transistor of the first stack 130. In other words, the first stack 130 and the second stack 140 are cross-coupled via the coupling between (the source of) the transistor 134 and (the drain of) the transistor 143 as well as the coupling between (the source of) the transistor 144 and (the drain of) the transistor 133.

The switch circuit 100 is suitable for high-voltage applications exceeding the maximum tolerable input voltage of the individual transistor device. Modern semiconductor technology nodes such as nodes using Gate-All-Around Field-Effect Transistors (GAAFETs) with nanosheets (also known as RibbonFET transistors) or Complementary Field-Effect Transistors (CFETs) with nanosheets come with low breakdown voltages (e.g., below 3 V) and low supply voltages (e.g., 1.2 V). Stacking the transistors as illustrated in Fig. 1 allows to provide a transistor-based switch exceeding the voltage limitations of the individual transistor. In other words, the maximum tolerable voltage is enhanced by stacking the transistors (e.g., thin-oxide transistors) in series to achieve a desired power handing capability. V_{EoS_max} is the is the maximum tolerable (allowed) voltage per transistor and depends on the semiconductor technology node. For example, for a node using RibbonFET transistors, V_{EoS_max} < 0.9 V such that the four stacked transistors in each of the stacks 130 and 140 allows for a voltage limit of 4 x V_{EoS_max} = 3.6 V, or equivalently +18 dBm on a 100 Ω - balanced front-end input impedance. The above numbers are only an illustrative example and are not limiting the proposed architecture. The cross-coupled stacking of the p-type and n-type transistors as illustrated in Fig. 1 allows to maintain a very high level of symmetry and linearity as the parallel paths are balanced and symmetric.

The equivalent total-on resistance R_{ON} of the switch circuit 100 is given by the parallel of the two series on-resistances of the pin-type transistors forming the first stack 130 and the second stack 140. The configuration is fully symmetric (the two paths between the nodes 110 and 120 are equal) to achieve highest linearity.

As indicated above, the switch circuit 100 may be implemented in a modern semiconductor technology node. For example, the transistors of the first and the second stack 130, 140 may be GAAFETs with nanosheets (e.g., RibbonFET transistors) or CFETs with nanosheets. For example, RibbonFET process technology offers the advantage of missing bulks (and associated wells) and substrate, resulting in a significant reduction of non-linearity induced by threshold voltage shift due to transistor bulk modulation, reduced area (compact layout), avoided latch-up risks, and lower parasitic devices. However, the present disclosure is not limited thereto. In general, the proposed switch circuit architecture may be used with any semiconductor technology node.

A respective voltage clamp 151, 152, 153 and 154 is coupled between the sources of the transistors 131 and 142, the drains of the transistors 132 and 142, the drains of the transistors 133 and 143 and the sources of the transistors 134 and 144. In the example of Fig. 1, the respective voltage clamp 151, 152, 153 and 154 is formed by a respective set of two back-to-back diodes. However, the present disclosure is not limited thereto. In alternative examples, the respective voltage clamp 151, 152, 153 and 154 may be formed by a respective semiconductor switch (e.g., formed by one or more n-type transistor and/or a p-type transistor). In still further examples, the respective voltage clamp 151, 152, 153 and 154 may be formed by a respective transmission gate (e.g., with p-type and n-type transistors in parallel). The transistors of the respective transmission gate may be of the same type (e.g., p-type or n-type) like the transistors between which the respective transmission gate is coupled to track process and temperature variations. For example, gates of transistors of the respective transmission gate may be configured to receive the same signals as the gates of transistors between which the respective transmission gate is coupled (e.g., the gates of the transistors forming the transmission gate between the sources of the transistors 131 and 141 may be configured to receive the same signals as the gates of the transistors 131 and 141 for controlling the conductive state of the transmission gate). In case of over- or undervoltage, the electrical stress is damped with charge distribution in the switch circuit 100 and is controlled via the voltage clamps 151, 152, 153 and 154. The voltage clamps 151, 152, 153 and 154 equalize the source or drain voltage of the transistors between which the respective voltage clamp is coupled (e.g., the voltage clamp 151 equalizes the source voltage of the transistors 131 and 141), especially during the off-state of the transistors and, hence, the switch circuit 100. The voltage clamps 151, 152, 153 and 154 allow to keep the drain-gate-source voltages of the transistors of the first stack 130 and the second stack 140 with a safe operating range by acting as fast passive clamps without additional penalty in current consumption (especially during the off-state of the transistors and, hence, the switch circuit 100). This also holds true when high-frequency RF signals are applied to the first and second nodes 110 and 120.

The switch circuit 100 further comprises a third node 160 configured to receive a DC reference voltage (common mode voltage) V_{cm}. The third node is resistively coupled between (the sources of) the transistors 132 and 133 and between (the sources of) the transistors 142 and 143. Assuming that the supply voltages of the switch circuit 100 are the first supply voltage V_{DD} and the second supply voltage Vss with Vss < V_{DD}, the DC reference voltage may be V_{cm} = ½ V_{DD}. The third node 160 as well as its couplings to the first stack 130 and the second stack 140 are arranged on the line of symmetry 105 of the switch circuit 100. The first stack 130 and the second stack 130 are symmetric with respect to the line of symmetry. The DC reference voltage V_{cm} allows to balance the switch circuit 100.

The switch circuit 100 comprises control circuitry 170 for controlling the respective conductive state of the transistors forming the first stack 130 and the second stack 140. In particular, the control circuitry 170 is configured to supply a respective control signal to the respective gate (terminal) of the transistors of the first stack130 and the second stack 140 to control on- and off-state of the transistors. In the example of Fig. 1, respective sub-circuit 171, ..., 178 for controlling the on- and off-state of the respective transistor is illustrated. The sub-circuits 171, ..., 178 form the control circuitry 170.

A respective resistor is coupled between the respective gate of the transistors of first and the second stack 130, 140 and the control circuitry 170. In particular, a respective resistor is coupled between the respective gate of the transistors of first and the second stack 130, 140 and the respective sub-circuit 171, ..., 178. The resistors allow to enhance the bandwidth of the switch circuit 100 by neutralizing device parasitic capacitances (e.g., gate-source and gate-drain parasitic capacitances). The resistors are optional any may be omitted in alternative examples (e.g., in case of limited chip area).

By controlling the respective conductive state of the transistors forming the first stack 130 and the second stack 140, the first node 110 and the second 120 may be coupled and decoupled in a controlled manner. For example, for electrically coupling the first node 110 and the second node 120, the control circuitry 170 may be configured to adjust a respective signal level of the respective control signal to control the transistors of the first and the second stack 130 and 140 to be in the on-state. For example, the transistors of first and the second stack 130 and 140 may be controlled via the respective control signal to be in a strong depletion mode. The signal level of the control signals for the p-type transistors 131, 132, 143 and 144 may, e.g., be set to Vss to turn these transistors on and drive them into the strong depletion mode. Similarly, the signal level of the control signals for the n-type transistors 141, 142, 133 and 134 may, e.g., be set to V_{DD} to turn these transistors on and drive them into the strong depletion mode.

For example, for electrically decoupling the first node 110 from the second node 120, the control circuitry 170 may be configured to adjust the respective signal level of the respective control signal to control the transistors of the first and the second stack 130 and 140 to be in the off-state. For example, the transistors of first and the second stack 130 and 140 may be controlled via the respective control signal to be in a strong enhancement mode or a strong accumulation mode to avoid unwanted self-turn on of the transistors due to a voltage swing (e.g., an RF voltage swing) received at the first and the second node 110, 120. When the transistors of the first and the second stack 130 and 140 and, hence, the switch circuit 100 is in the off-state, the gate capacitances of the transistors are evenly split (i.e., C_{gs} = C_{gd} = C_{g}/2). This allows to equally divide the voltage difference between first and the second node 110, 120 across the stacked transistors. The signal level of the control signals for the p-type transistors 131, 132, 143 and 144 may, e.g., be set to V_{DD} to turn these transistors off and drive them into the strong enhancement mode (or strong accumulation mode). Similarly, the signal level of the control signals for the n-type transistors 141, 142, 133 and 134 may, e.g., be set to Vss to turn these transistors off and drive them into the strong enhancement mode (or strong accumulation mode).

The biasing control of the transistors of the first stack 130 and the second stack 140 may be static (i.e., no current is needed). In other words, no current consumption may be required to set and maintain the quiescent point of the transistors of the first stack 130 and the second stack 140.

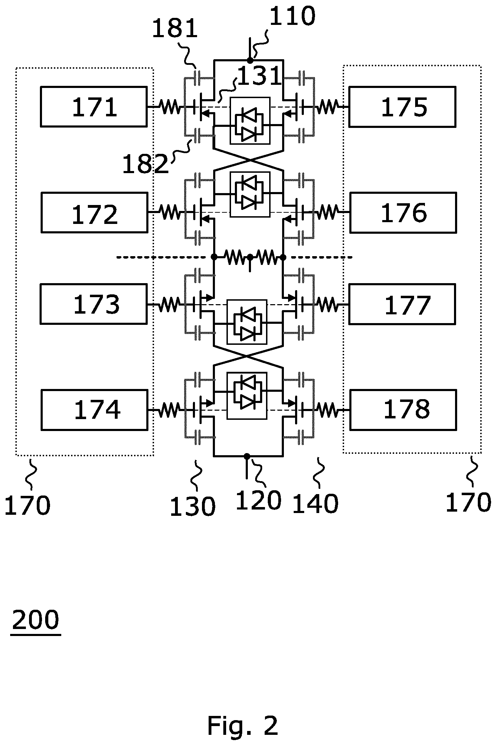

**Fig. 2** illustrates another switch circuit 200 which is based on the switch circuit 100 described above. In comparison to the switch circuit 100, a respective capacitor is additionally coupled between the respective gate and the respective source of the transistors of the first and the second stack 130, 140. Similarly, a respective capacitor is additionally coupled between the respective gate and the respective drain of the transistors of the first and the second stack 130, 140. For example, the capacitor 181 is coupled between the gate and the drain of the transistor 131 and the capacitor 182 is coupled between the gate and the source of the transistor 131.

The additional capacitors improve the balancing of the switch circuit 200 compared to the switch circuit 100.

In the example of Fig. 1 and 2, each of the first stack 130 and the second stack 140 comprises four transistors. However, it is to be noted that the present disclosure is not limited thereto. Each of the first stack 130 and the second stack 140 may optionally comprise additional transistors. For example, N additional p-type transistors coupled in series with N additional n-type transistors may be coupled in series between the transistors 132 and 133 of the first stack 130 and N additional n-type transistors coupled in series with N additional p-type transistors may be coupled in series between the transistors 142 and 143 of the second stack 140 (with N being an integer). Additionally or alternatively, M additional p-type transistors may be coupled in series between the first node 110 and the transistor 131 of the first stack 130, M additional n-type transistors may be coupled in series between the second node 120 and the transistor 134 of the first stack 130, M additional n-type transistors may be coupled in series between the first node 110 and the transistor 141 of the second stack 140 and M additional p-type transistors may be coupled in series between the second node 120 and the transistor 144 of the second stack 140 (with M being an integer). Also, the switch circuits may comprise further pairs cross-couplings between the optional additional transistors of the first stack 130 and the second stack 140 (i.e., 2, 4, 6, 8, etc. additional cross couplings).

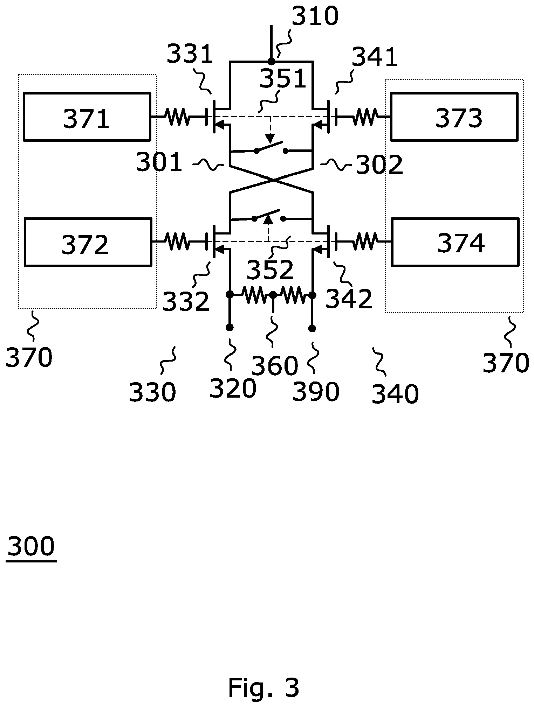

The switch circuits 100 and 200 described above are designed mainly for usage in differential circuitry. However, the proposed architecture is not limited to differential implementations. The proposed architecture may be used for single-ended implementations as well. An exemplary switch circuit 300 which may be used in single-ended circuitry is illustrated in **Fig. 3****.**

The switch circuit 300 comprises a first node 310 for coupling to a conductive path. For example, the conductive path may be a signal path (line, trace) of a single-ended circuit such as an attenuator (e.g., a DSA).

Furthermore, the switch circuit 300 comprises a second node 320 for coupling to ground or a supply voltage such as Vss. Additionally, the switch circuit 300 comprises a third node 390 for coupling to ground or the supply voltage.

The switch circuit 300 comprises a first stack of transistors 330 arranged between the first node 310 and the second node 320. Additionally, the switch circuit 300 comprises a second stack of transistors 340 arranged between the first node 310 and the third node 190. That is, the first node 310 is arranged above the first stack 330 and the second stack 340, whereas each of the second node 320 and the third node 390 is arranged below the first stack 330 and the second stack 340. The first stack 330 comprises the two transistors 331 and 332 vertically stacked on top of each other. The second stack 340 comprises the two transistors 341 and 342 vertically stacked on top of each other. The first stack 330 is arranged left of the second stack 340. In other words, the first stack 330 and the second stack 340 are arranged laterally offset from each other.

In the example of Fig. 3, the transistors 331 and 332 are p-type transistors (being an example for transistors of a first conductivity type) and the transistors 341 and 342 are n-type transistors (being an example for transistors of a second conductivity type). However, it is to be noted that the present disclosure is not limited thereto. In other examples, the transistors 331 and 332 may be n-type transistors and the transistors 341 and 342 may be p-type transistors. In general, the transistors 331 and 332 are of a first conductivity type and the transistors 341 and 342 are of a second conductivity type different from the first conductivity type.

The drain (terminal) of the transistor 331, which may be referred to as the "first transistor of the first stack" in the present disclosure, is coupled to the first node 310. The source (terminal) of the transistor 332, which may be referred to as the "second transistor of the first stack" in the present disclosure, is coupled to the second node 320.

Similarly, the drain (terminal) of the transistor 341, which may be referred to as the "first transistor of the second stack" in the present disclosure, is coupled to the first node 310. The source (terminal) of the transistor 342, which may be referred to as the "second transistor of the second stack" in the present disclosure, is coupled to the third node 390.

The source (terminal) of the transistor 331 is coupled to the drain (terminal) of the transistor 342. The source (terminal) of the transistor 341 is coupled to the drain (terminal) of the transistor 332. Accordingly, a first conductive trace (path) 301 coupling (the source of) the transistor 331 and (the drain of) the transistor 342 crosses a second conductive trace (path) 302 coupling (the source of) the transistor 341 and (the drain of) the transistor 332. That is, the first transistor of the first stack 330 is cross-coupled with the second transistor of the second stack 340 and the first transistor of the second stack 340 is cross-coupled with the second transistor of the first stack 330. In other words, the first stack 330 and the second stack 340 are cross-coupled via the coupling between (the source of) the transistor 331 and (the drain of) the transistor 342 as well as the coupling between (the source of) the transistor 341 and (the drain of) the transistor 332.

Like the switch circuits 100 and 200, also the switch circuit 300 is suitable for high-voltage applications exceeding the maximum tolerable input voltage of the individual transistor device. Stacking the transistors as illustrated in Fig. 3 allows to provide a transistor-based switch exceeding the voltage limitations of the individual transistor, which makes the switch circuit 300 particularly suitable for modern semiconductor technology nodes with low breakdown voltages and low supply voltages. For example, for the maximum tolerable (allowed) voltage per transistor V_{EoS_max}, the two stacked transistors in each of the stacks 330 and 340 allow for a voltage limit of 2 x V_{EoS_max}. The cross-coupled stacking of the p-type and n-type transistors as illustrated in Fig. 3 allows to maintain a very high level of symmetry and linearity as the parallel paths are balanced and symmetric.

As indicated above, the switch circuit 100 may be implemented in a modern semiconductor technology node. For example, the transistors of the first and the second stack 330, 340 may be GAAFETs with nanosheets (e.g., RibbonFET transistors) or CFETs with nanosheets. However, the present disclosure is not limited thereto. In general, the proposed switch circuit architecture may be used with any semiconductor technology node.

The equivalent total-on resistance R_{ON} of the switch circuit 300 is given by the parallel of the two series on-resistances of the pin-type transistors forming the first stack 330 and the second stack 340. The configuration is fully symmetric (the path from the first node 310 to the second node 320 is substantially equal to path from the first node 310 to the third node 390) to achieve highest linearity.

A respective voltage clamp 351 and 352 is coupled between the sources of the transistors 331 and 342 and the drains of the transistors 332 and 342. In the example of Fig. 3, the respective voltage clamp 351 and 352 is formed by a respective semiconductor switch. However, the present disclosure is not limited thereto. In alternative examples, the respective voltage clamp 351 and 352 may be formed by a respective set of two back-to-back diodes or a respective transmission gate similar to what is described above for the switch circuit 100. The transistors of the respective transmission gate may be of the same type (e.g., p-type or n-type) like the transistors between which the respective transmission gate is coupled to track process and temperature variations. For example, gates of transistors of the respective transmission gate may be configured to receive the same signals as the gates of transistors between which the respective transmission gate is coupled (e.g., the gates of the transistors forming the transmission gate between the sources of the transistors 331 and 341 may be configured to receive the same signals as the gates of the transistors 331 and 341 for controlling the conductive state of the transmission gate). In case of over- or undervoltage, the electrical stress is damped with charge distribution in the switch circuit 300 and is controlled via the voltage clamps 351 and 352. The voltage clamps 351 and 352 equalize the source or drain voltage of the transistors between which the respective voltage clamp is coupled. The voltage clamps 351 and 352 allow to keep the drain-gate-source voltages of the transistors of the first stack 130 and the second stack 140 with a safe operating range by acting as fast passive clamps without additional penalty in current consumption.

The switch circuit 300 further comprises a fourth node 360 configured to receive a DC reference voltage (common mode voltage) V_{cm}. The third node 360 is resistively coupled between (the source of) the transistor 332 and the second node 120 and between (the source of) the transistor 342 and the third node 390. Assuming that the supply voltages of the switch circuit 300 are the first supply voltage V_{DD} and the second supply voltage Vss with Vss < V_{DD}, the DC reference voltage may be V_{cm} = ½ V_{DD}. The DC reference voltage V_{cm} allows to balance the switch circuit 300.

Although not explicitly illustrated in Fig. 3, a respective capacitor may additionally be coupled between the respective gate and the respective source of the transistors of the first and the second stack 330, 340. Similarly, a respective capacitor may additionally be coupled between the respective gate and the respective drain of the transistors of the first and the second stack 330, 340. The additional capacitors allow to further improve the balancing of the switch circuit 300.

The switch circuit 300 comprises control circuitry 370 for controlling the respective conductive state of the transistors forming the first stack 330 and the second stack 340. In particular, the control circuitry 370 is configured to supply a respective control signal to the respective gate (terminal) of the transistors of first 330 and the second stack 340 to control on- and off-state of the transistors. In the example of Fig. 3, respective sub-circuit 371, ..., 374 for controlling the on- and off-state of the respective transistor is illustrated. The sub-circuits 371, ..., 374 form the control circuitry 170.

A respective resistor is coupled between the respective gate of the transistors of first and the second stack 330, 340 and the control circuitry 370. In particular, a respective resistor is coupled between the respective gate of the transistors of first and the second stack 330, 340 and the respective sub-circuit 371, ..., 374. The resistors allow to enhance the bandwidth of the switch circuit 300 by neutralizing device parasitic capacitances (e.g., gate-source and gate-drain parasitic capacitances). The resistors are optional any may be omitted in alternative examples (e.g., in case of limited chip area).

By controlling the respective conductive state of the transistors forming the first stack 330 and the second stack 340, the first node 310 may be coupled to and decoupled from the second and third nodes 320, 390 in a controlled manner. For example, for electrically coupling the first node 310 with the second and third node 320, 390, the control circuitry 370 may be configured to adjust a respective signal level of the respective control signal to control the transistors of first and the second stack 330 and 340 to be in the on-state. For example, the transistors of first and the second stack 330 and 340 may be controlled via the respective control signal to be in a strong depletion mode. The signal level of the control signals for the p-type transistors 331 and 332 may, e.g., be set to Vss to turn these transistors on and drive them into the strong depletion mode. Similarly, the signal level of the control signals for the n-type transistors 341 and 342 may, e.g., be set to V_{DD} to turn these transistors on and drive them into the strong depletion mode.

For example, for electrically decoupling the first node 310 from the second and third node 320, 390, the control circuitry 370 may be configured to adjust the respective signal level of the respective control signal to control the transistors of the first and the second stack 330 and 340 to be in the off-state. For example, the transistors of first and the second stack 330 and 340 may be controlled via the respective control signal to be in a strong enhancement mode or a strong accumulation mode to avoid unwanted self-turn on of the transistors. The signal level of the control signals for the p-type transistors 331 and 332 may, e.g., be set to V_{DD} to turn these transistors off and drive them into the strong enhancement mode (or strong accumulation mode). Similarly, the signal level of the control signals for the n-type transistors 341 and 142 may, e.g., be set to Vss to turn these transistors off and drive them into the strong enhancement mode (or strong accumulation mode).

The biasing control of the transistors of the first stack 330 and the second stack 340 may be static (i.e., no current is needed). In other words, no current consumption may be required to set and maintain the quiescent point of the transistors of the first stack 130 and the second stack 140.

In the example of Fig. 3, each of the first stack 330 and the second stack 340 comprises two transistors. However, it is to be noted that the present disclosure is not limited thereto. Each of the first stack 130 and the second stack 140 may optionally comprise additional transistors. L additional p-type transistors may be coupled in series between the first node 310 and the transistor 331 of the first stack 330, L additional p-type transistors may be coupled in series between the second node 320 and the transistor 332 of the first stack 330, L additional n-type transistors may be coupled in series between the first node 310 and the transistor 341 of the second stack 340 and L additional n-type transistors may be coupled in series between the third node 390 and the transistor 342 of the second stack 340 (with L being an integer).

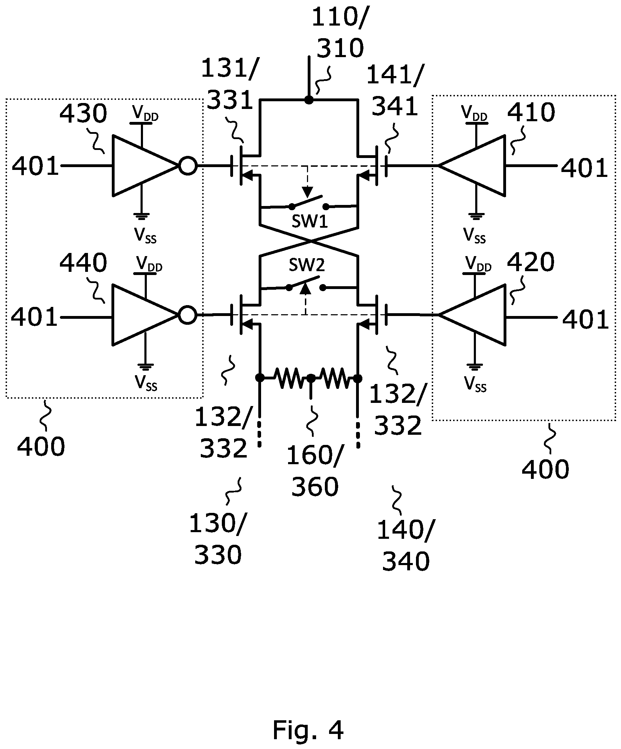

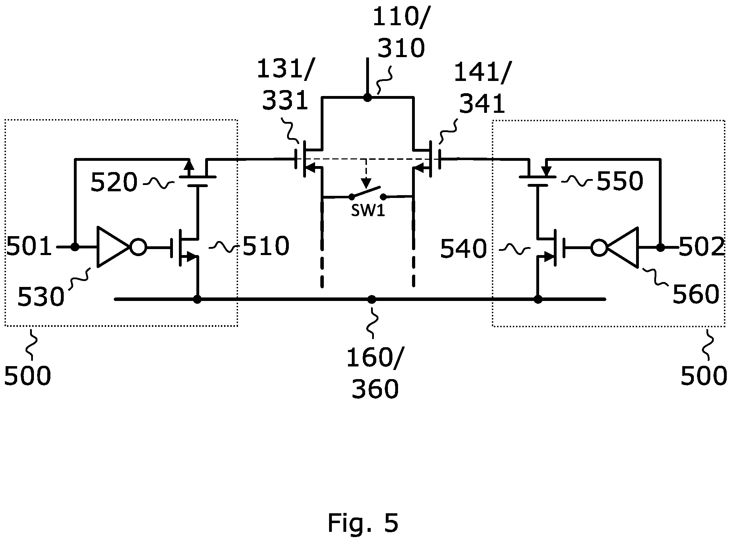

The general functionality of the control circuitry was explained above with respect to Fig. 1 and Fig. 3. In the following two more detailed examples of the control circuitry for the transistors in the first stack and the second stack are described with respect to Figs. 4 and 5. It is to be noted that the examples of Fig. 4 and Fig. 5 are illustrative examples and that the present disclosure is not limited thereto.

**Fig. 4** illustrates exemplary control circuitry 400. The control circuitry 400 may be used for any of the switch circuits 100, 200 and 300 described above. Further illustrated in Fig. 4 is the first node 110/310 of the switch circuit together with the first stack 130/330 (only half of the transistor stack 130 is depicted in Fig. 4) and the second transistor stack 140/340 (only half of the transistor stack 140 is depicted in Fig. 4) as described above. The lower part of the transistors is coupled to the second and third nodes as illustrated in Fig. 3 or via additional transistors of the opposite conductivity type to the second node as illustrated in Fig. 1 and Fig. 2.

The control circuitry 400 comprises two voltage buffers (e.g., amplifiers) 410 and 420 coupled to the respective gate (terminal) of the n-type transistors 141/341 and 142/342 of the second stack 140/340. Furthermore, the control circuitry 400 comprises two inverting voltage buffers (e.g., inverting amplifiers) 430 and 440 coupled to the respective gate (terminal) of the p-type transistors 131/331 and 132/332 of the first stack 130/330.

The voltage buffers 410 and 420 as well as the inverting voltage buffers 430 and 440 are configured to receive a switch control signal 401 and to generate the respective control signal for the respective transistor based on the switch control signal 401. In particular, the inverting voltage buffers 430 and 440 generate the control signals for the transistors 131/331 and 132/332 by inverting the switch control signal 401. The voltage buffers 410 and 420 output the buffered switch control signal 401 as control signals for the transistors 141/341 and 142/342.

The voltage buffers 410 and 420 as well as the inverting voltage buffers 430 and 440 receive a first supply voltage V_{DD} and a second supply voltage Vss. The voltage buffers 410 and 420 as well as the inverting voltage buffers 430 and 440 generate the respective control signal with a voltage (signal) level between a voltage level of the first supply voltage V_{DD} and a voltage (signal) level of the second supply voltage Vss. For example, the voltage level of the control signals for the p-type transistors 131/331 and 132/332 may be Vss and the voltage level of the control signals for the n-type transistors 141/341 and 142/342 may V_{DD} to turn these transistors on. Similarly, the voltage level of the control signals for the p-type transistors 131/331 and 132/332 may be V_{DD} and the voltage level of the control signals for the n-type transistors 141/341 and 142/342 may Vss to turn these transistors off.

It is to be noted that in alternative examples, the two voltage buffers 410 and 420 may be coupled to the gates of the p-type transistors 131/331 and 132/332 of the first stack 130/330 and the two inverting voltage buffers 430 and 440 may be coupled to the gates of the n-type transistors 141/341 and 142/342 of the second stack 140/340.

In case the control circuitry 400 is used for the switch circuits 100 and 200 described above and illustrated in Fig. 1 and Fig. 2, the control circuitry 400 comprises further voltage buffers coupled to the gates of the transistors 133 and 134 as well as further inverting voltage buffers coupled to the gates of the transistors 143 and 144.

Speaking more general, the control circuitry 400 comprises a plurality of voltage buffers (each) coupled to the respective gate of either the transistors of the first conductivity type or the transistors of the second conductivity type in the first and the second stack. Additionally, the control circuitry 400 comprises a plurality of inverting voltage buffers (each) coupled to the respective gate of the other of the transistors of the first conductivity type and the transistors of the second conductivity type. The plurality of voltage buffers and the plurality of inverting voltage buffers are configured to receive a switch control signal and to generate the respective control signal for the respective transistor based on the switch control signal. As indicated in Fig. 4, the plurality of voltage buffers and the plurality of inverting voltage buffers may be configured to receive a first supply voltage and a second supply voltage and to generate the respective control signal with a voltage level between a voltage level of the first supply voltage and a voltage level of the second supply voltage.

The control circuitry 400 allows a direct gate driving with level-shifted signals. Omitting further resistors between the transistor gates and the (inverting) voltage buffers allows to save chip area at cost of reduced overall linearity when using the switch circuit in an attenuation circuit (which makes the trade-off between the on-resistance R_{ON} and the off-capacitance C_{OFF} harder). The control circuitry 400 for the proposed high-voltage switch is a static biasing control circuitry. A switch circuit with the control circuitry may be used for each parallel shunt path off an attenuation circuit such as a DSA as it allows for almost zero current consumption (effectively only gate leakage) for the different switch states (e.g., on and off).

**Fig. 5** illustrates an alternative control circuitry 500. The control circuitry 500 may be used for any of the switch circuits 100, 200 and 300 described above. For reasons of simplicity, Fig. 5 illustrates the control circuitry 500 only for the first transistor of the first stack and the first transistor of the second stack. Accordingly, only the first transistor of the first stack and the first transistor of the second stack are illustrated in Fig. 5. The control circuitry 500 may comprise analogous elements and functionality also for the other transistors of the respective stack.

The control circuitry 500 comprises a first n-type transistor 510. The source (terminal) of the first transistor 510 is coupled to the third node 160/fourth node 360 providing the DC reference voltage. Further, the control circuitry 500 comprises second n-type transistor 520. The drain (terminal) of the second n-type transistor 520 is coupled to the gate of the transistor 131/331 of the first stack. The gate (terminal) of the second n-type transistor 520 is coupled to the drain (terminal) of the first n-type transistor 510.

Additionally, the control circuitry 500 comprises a first inverting voltage buffer (e.g., an amplifier) 530 configured to receive a first switch control signal 501 at its input (node). The output (node) of the first inverting voltage buffer 530 is coupled to the gate (terminal) of the first n-type transistor 510. The input of the first inverting voltage buffer 530 is further coupled to the source (terminal) of the second n-type transistor 520.

The control circuitry 500 further comprises a first p-type transistor 540. The source (terminal) of the first transistor 550 is coupled to the third node 160/fourth node 360 providing the DC reference voltage. Further, the control circuitry 500 comprises a second p-type transistor 550. The drain (terminal) of the second p-type transistor 550 is coupled to the gate of the transistor 141/341 of the second stack. The gate (terminal) of the second p-type transistor 550 is coupled to the drain (terminal) of the first p-type transistor 540.

Additionally, the control circuitry 500 comprises a second inverting voltage buffer (e.g., amplifier) 560 configured to receive a second switch control signal 502 at its input (node). The output (node) of the second inverting voltage buffer 560 is coupled to the gate (terminal) of the first p-type transistor 540. The input of the second inverting voltage buffer 560 is further coupled to the source (terminal) of the second p-type transistor 550.

The first switch control signal 501 and the second switch control signal 502 are inverted with respect to each other.

The inverting voltage buffers 530 and 560 receive a first supply voltage V_{DD} and a second supply voltage Vss.

The output signals at the drains of the transistors 520 and 550 are the control signals for transistors 131/331 and 141/341 of the first and second stack.

Compared to the control circuitry 400, the control circuitry 500 avoids the usage of level-shifters with full (rail-to-rail) output voltage swing V_{DD} - Vss. Instead, the control signals are generated with respect the common-mode reference voltage provided by the third node 160/fourth node 360.

Compared to the control circuitry 400, the control circuitry 500 allows to reduce chip area consumption, complexity and parasitics.

In the example of Fig. 5, the transistors 510 and 520 are n-type transistors. However, it is to be noted that the present disclosure is not limited thereto. In general, the conductivity of the of the transistors 510 and 520 depends on the conductivity of the respective transistor in the first stack to which the transistor 520 is coupled. In other words, if the transistor 131/331 of the first stack (or any other transistor of the first stack to which the transistor 520 is coupled) is of a first conductivity, the transistors 510 and 520 are of a second conductivity type, and vice versa. Similarly, the conductivity of the of the transistors 540 and 550 depends on the conductivity of the respective transistor in the second stack to which the transistor 550 is coupled. In other words, if the transistor 141/341 of the second stack (or any other transistor of the second stack to which the transistor 550 is coupled) is of a second conductivity, the transistors 540 and 550 are of a first conductivity type, and vice versa.

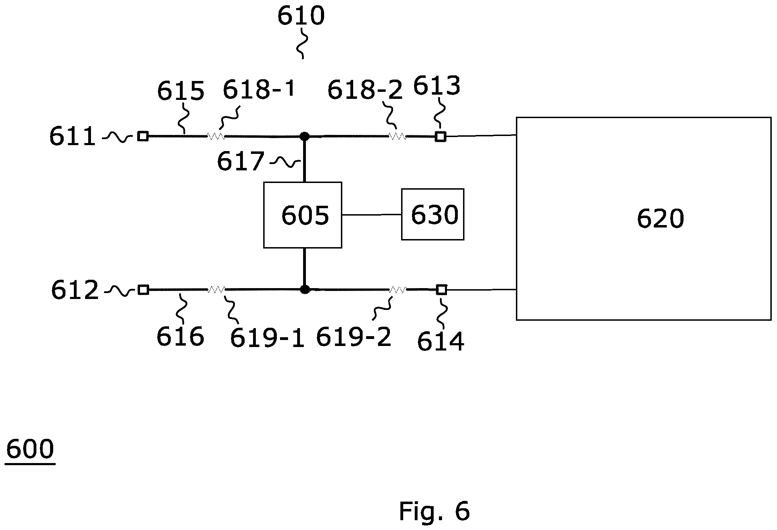

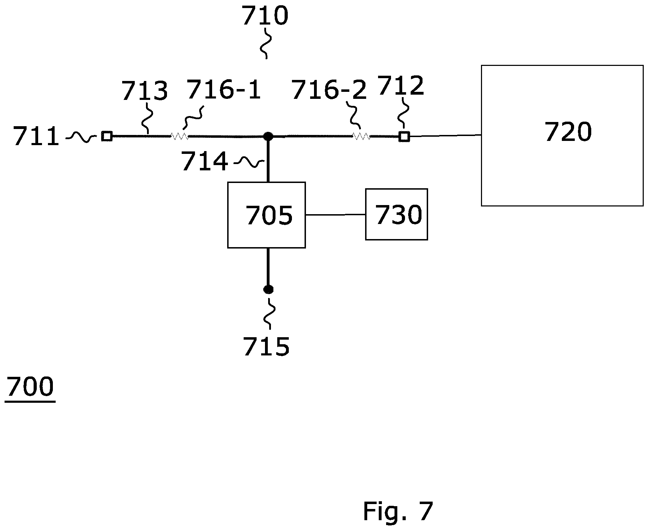

As indicated above, switch circuits according to the proposed technique may be used in attenuation circuits such as DSAs. In the following two exemplary receivers with attenuation circuits using switch circuits according to the proposed technique will be described with reference to Figs. 6 and 7. It is to be noted that although the switch circuits according to the proposed technique are described with reference to attenuation circuits, the switch circuits according to the proposed technique may be used for other applications as well.

**Fig. 6** illustrates a receiver 600. The receiver comprises an attenuation circuit 610.

The attenuation circuit 610 comprises a first input node 611 and a second input node 612 each configured to receive a respective one of a first input signal and a second input signal forming a differential input signal pair. For example, the first input node 611 may receive the first input signal of the differential input signal pair and the second input node 612 may receive the second input signal of the differential input signal pair. The first input signal and the second input signal received by the input nodes 611 and 612 may, e.g., be RF signals. For example, the RF signals may be RF receive signals provided by an antenna element.

Additionally, the attenuation circuit 610 comprises a first output node 613 and a second output node 614 each configured to output a respective one of a first output signal and a second output signal forming a differential output signal pair. For example, the first output node 613 may output the first output signal of the differential output signal pair and the second output node 614 may output the second output signal of the differential output signal pair.

A first signal path 615 is coupled between the first input node 611 and the first output node 613. Similarly, a second signal path 616 is coupled between the second input node 612 and the second output node 614.

The first signal path 615 comprises two resistive elements 618-1 and 618-2 coupled in series between the first input node 611 and the first output node 613. However, it is to be noted the present disclosure is not limited thereto. In general any number F ≥ 2 of resistive elements may be coupled between the first input node 611 and the first output node 613 (F being an integer). In other words, the first signal path 615 comprises a first plurality of resistive elements.

The second signal path 616 comprises two resistive elements 619-1 and 619-2 coupled in series between the second input node 612 and the second output node 614. However, it is to be noted the present disclosure is not limited thereto. In general any number G ≥ 2 of resistive elements may be coupled between the second input node 612 and the second output node 614 (G being an integer which may be equal to or be different from F). In other words, the second signal path 616 comprises a second plurality of resistive elements.

In the example of Fig. 6, each of the resistive elements 618-1 and 618-2 as well as the resistive elements 619-1 and 619-2 is a single resistor. In other examples, the resistive elements 618-1 and 618-2 as well as the resistive elements 619-1 and 619-2 may comprise a respective plurality of resistors coupled in parallel. According to examples, the first plurality of resistive elements and the second plurality of resistive elements may be formed identical with respect to each other. In other examples, the first plurality of resistive elements and the second plurality of resistive elements may be formed different with respect to each other. For example, at least a part of the first plurality of resistive elements and/or the second plurality of resistive elements may respectively be a single resistor. In other examples, at least a part of the first plurality of resistive elements and/or the second plurality of resistive elements may respectively comprise a plurality of resistors coupled in parallel. The resistances of each of the first plurality of resistive elements may be identical to or be different from each other. Similarly, the resistances of each of the second plurality of resistive elements may be identical to or be different from each other.

The attenuation circuit 610 additionally comprises a shunt path 617 coupled between the first signal path 615 and the second signal path 616. The shunt path 617 may be coupled to the first signal path 615 between any two (directly succeeding) resistive elements of the first plurality of resistive elements. Analogously, the shunt path 617 may be coupled to the second signal 616 path between any two (directly succeeding) resistive elements of the second plurality of resistive elements.

The shunt path 617 comprises a switch circuit 605 according to the present disclosure to selectively couple (shunt) the first signal path 615 and the second signal path 616. As the receiver 600 is a differential receiver, the switch circuit 605 may, e.g., be one of the switch circuits 100 and 200 described above.

In case the switch circuit 605 does not couple the first signal path 615 and the second signal path 616, the first input signal and the second input of the differential input signal pair are not attenuated by the attenuation circuit 610. This state of the attenuation circuit 610 may be understood as a referenced or through state. In case the switch circuit 605 couples the first signal path 615 and the second signal path 616, the first input signal and the second input of the differential input signal pair are attenuated by the attenuation circuit 610. This state of the attenuation circuit 610 may be understood as an attenuation state. The attenuation circuit 100 may, hence, enable selective signal attenuation.

The switch circuit 605 in the shunt path 617 is configured to selectively couple the first signal path 615 and the second signal path 616 based on at least one switch control signal. The at least one switch control signal is generated by an attenuation control circuit 630 of the receiver 600 to control coupling of the first signal path 615 and the second signal path 615 by the switch circuit 605 in the shunt path 617. For example, the attenuation control circuit 630 may be configured to control coupling of the first signal path 615 and the second signal path 615 by the switch circuit 605 in the shunt path 617 based on a target attenuation of the first input signal and the second input signal. The target attenuation is a desired attenuation of the first input signal and the second input signal by the attenuation circuit 610. For example, the control circuit 630 may determine the target attenuation based on a signal power of the first input signal and the second input signal to the attenuation circuit 610 (e.g. indicated by a signal envelope of the first input signal and the second input signal). For example, if the switch circuit 605 uses the control circuitry 400 described above, the attenuation control circuit 630 may supply a single switch control signal to the switch circuit 605. On the other hand, if the switch circuit 605 uses the control circuitry 500 described above, the attenuation control circuit 630 may supply two switch control signal to the switch circuit 605 which are inverted with respect to each other.

Optionally, the shunt path 617 may comprise more than one switch circuit 605 according to the present disclosure. Accordingly, the attenuation control circuit 630 may generate at least one respective switch control signal for each switch circuit of the shunt path.

Similarly, the attenuation circuit 610 may comprise more than one shunt path comprising at least one respective switch circuit according to the present disclosure to selectively couple the first signal path 615 and the second signal path 616. The multiple shunt paths may be coupled to the first signal path 615 between different resistive element pairs of the first plurality of resistive elements. Similarly, the multiple shunt paths may be coupled to the second signal path 616 between different resistive element pairs of the second plurality of resistive elements. For example, an attenuation circuit according to the present disclosure may comprise two, three, four or more shunt paths for selectively coupling the first signal path 615 and the second signal path 616 at different intermediate nodes. Due to the linearity of the circuit arrangement, cascading (superposition) of multiple parallel shunt paths allows to extend the attenuation range of the attenuation circuit. For example, the total attenuation of an attenuation circuit according to the present disclosure may be given by the sum of the attenuation of each parallel shunt path.

The attenuation control circuit 630 may generate at least one respective switch control signal for each switch circuit of each shunt path.

By selective coupling and decoupling the first signal path 615 and the second signal path 616 via the switch circuits in one or more shunt paths, the attenuation of the attenuation circuit 610 may be varied in defined steps. Accordingly, an attenuation circuit according to the present disclosure may be understood as a DSA.

A load 620 is coupled to the output nodes 613 and 614 of the attenuation circuit 610 for further processing the differential output signal pair. The load 620 may, e.g., be one or more input buffers of an Analog-to-Digital Converter (ADC).

**Fig. 7** illustrates a single-ended receiver 700. The receiver 700 comprises an attenuation circuit 710.

The attenuation circuit 710 comprises an input node 711 and an output node 712. A signal path 713 is coupled between the input node 711 and the output node 712. The input node 711 is configured to receive an input signal. The output node is configured to output an output signal. The input signal received by the input node 611 may, e.g., be an RF signal. For example, the RF signal may be an RF receive signal provided by an antenna element.

The signal path 713 comprises two resistive elements 716-1 and 716-2 coupled in series between the input node 711 and the output node 712. However, it is to be noted the present disclosure is not limited thereto. In general any number H ≥ 2 of resistive elements may be coupled between the input node 711 and the output node 712 (H being an integer). In other words, the signal path 713 comprises a plurality of resistive elements.

The attenuation circuit 710 additionally comprises a shunt path 714 coupled between the signal path 713 and a node 715. The node 715 is either at ground or provides a supply voltage such as Vss. The shunt path 714 may be coupled to the signal path 713 between any two (directly succeeding) resistive elements of the plurality of resistive elements.

The shunt path 714 comprises a switch circuit 705 according to the present disclosure to selectively couple (shunt) the signal path 713 and the node 715 and, hence, ground or the supply voltage. As the receiver 700 is a single-ended receiver, the switch circuit 705 may, e.g., be the switch circuit 300 described above.

In case the switch circuit 705 does not couple the signal path 713 to ground or the supply voltage, the input signal is not attenuated by the attenuation circuit 710. This state of the attenuation circuit 710 may be understood as a referenced or through state. In case the switch circuit 705 couples the signal path 713 to ground or the supply voltage, the input signal is attenuated by the attenuation circuit 710. This state of the attenuation circuit 710 may be understood as an attenuation state. The attenuation circuit 700 may, hence, enable selective signal attenuation.

The switch circuit 705 in the shunt path 714 is configured to selectively couple the signal path 713 to ground or the supply voltage based on at least one switch control signal. The at least one switch control signal is generated by an attenuation control circuit 730 of the receiver 700 to control coupling of the signal path 713 to ground or the supply voltage by the switch circuit 705 in the shunt path 714. For example, the attenuation control circuit 730 may be configured to control coupling of the signal path 713 to ground or the supply voltage by the switch circuit 705 in the shunt path 714 based on a target attenuation of the input signal. The target attenuation is a desired attenuation of the input signal by the attenuation circuit 710. For example, the control circuit 730 may determine the target attenuation based on a signal power of the input signal (e.g. indicated by a signal envelope of the input signal). For example, if the switch circuit 705 uses the control circuitry 400 described above, the attenuation control circuit 730 may supply a single switch control signal to the switch circuit 705. On the other hand, if the switch circuit 705 uses the control circuitry 500 described above, the attenuation control circuit 730 may supply two switch control signal to the switch circuit 705 which are inverted with respect to each other.

Optionally, the shunt path 714 may comprise more than one switch circuit 705 according to the present disclosure. Accordingly, the attenuation control circuit 730 may generate at least one respective switch control signal for each switch circuit of the shunt path 714.

Similarly, the attenuation circuit 710 may comprise more than one shunt path comprising at least one respective switch circuit according to the present disclosure to selectively couple the signal path 713 to ground or the supply voltage. The multiple shunt paths may be coupled to the signal path 713 between different resistive element pairs of the plurality of resistive elements. For example, an attenuation circuit according to the present disclosure may comprise two, three, four or more shunt paths for selectively coupling the signal path 713 to ground or the supply voltage at different intermediate nodes. Due to the linearity of the circuit arrangement, cascading (superposition) of multiple parallel shunt paths allows to extend the attenuation range of the attenuation circuit. For example, the total attenuation of an attenuation circuit according to the present disclosure may be given by the sum of the attenuation of each parallel shunt path.

The attenuation control circuit 730 may generate at least one respective switch control signal for each switch circuit of each shunt path.

By selective coupling and decoupling the signal path 713 to ground or the supply voltage via the switch circuits in one or more shunt paths, the attenuation of the attenuation circuit 710 may be varied in defined steps. Accordingly, an attenuation circuit according to the present disclosure may be understood as a DSA.

A load 720 is coupled to the output node 712 of the attenuation circuit 710 for further processing the output signal. The load 620 may, e.g., be one or more input buffers of an ADC.

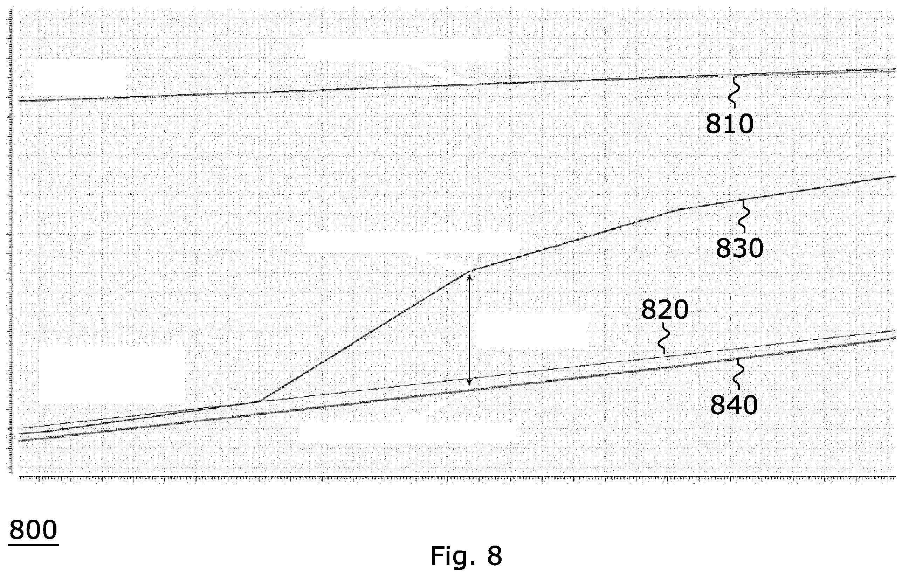

Fig. 8 illustrates a diagram 800 highlighting an exemplary comparison of linearities for different attenuation circuits. The linearity is measured for a two-tone test. The abscissa of diagram 800 denotes the input power, i.e., the power allocated per tone. The ordinate denotes the power of various signal parts output by the respective attenuation circuit.

As a reference, the curve 810 shows the power of the fundamental tone output by the attenuation circuits. The curve 820 shows an ideal course for the 3^{rd} order InterModulation Distortion (IMD3) with constant slope.

Curve 830 shows the IMD3 in the output of a conventional attenuation circuit. Curve 840 show the IMD3 in the output of an attenuation circuit according to the present disclosure.

As can be seen from curves 830 and 840, the linearity of the attenuation circuit according to the present disclosure is significantly improved due to the switch circuit(s) according to the proposed technique (e.g., by 30 dB or even more). This allows to significantly extend the range and the maximum (tolerable) input power of the attenuation circuit. For example, the range and the maximum (tolerable) input power of the attenuation circuit may be extended far beyond limits imposed by modern semiconductor technology nodes such RibbonFET process technology.

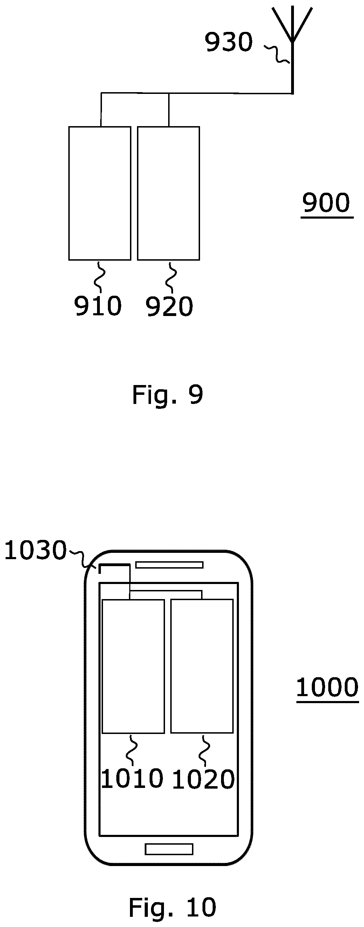

An example of an implementation using switch circuitry according to one or more aspects of the architecture described above in connection with Figs. 1 to 7 or one or more examples described above in connection with Figs. 1 to 7 is illustrated in Fig. 9. Fig. 9 schematically illustrates an example of a radio base station 900 (e.g. for a femtocell, a picocell, a microcell or a macrocell) comprising a receiver 910 as proposed.

The base station 900 comprises at least one antenna element 930 coupled to the receiver 910. The receiver 910 may be coupled to the antenna element 930 via one or more intermediate element such as one or more of a signal line, a filter, etc.

The receiver 910 comprises an attenuation circuit as proposed. For example, the receiver 910 may be one of the receivers 600 and 700 described above. The receiver 910 may comprise various further elements such as one or more of a Low-Noise Amplifier (LNA), a filter, a down-converter (mixer), ElectroStatic Discharge (ESD) protection circuitry, etc.

Additionally, the base station 900 comprises a transmitter 920 configured to generate a RF transmit signal. The transmitter 920 may use the antenna element 930 or another antenna element (not illustrated) of the base station 900 for radiating the RF transmit signal to the environment. For example, the transmitter 920 may be coupled to the antenna element 930 via one or more intermediate elements such as a filter, an up-converter (mixer) or a Power Amplifier (PA).

To this end, a base station with improved signal attenuation capabilities may be provided.

The base station 900 may comprise further elements such as, e.g., an application processor, a baseband processor, memory, a network controller, a user interface, power management circuitry, a satellite navigation receiver, a network interface controller or power tee circuitry.

In some aspects, the application processor may include one or more Central Processing Unit (CPU) cores and one or more of cache memory, a Low-DropOut (LDO) voltage regulator, interrupt controllers, serial interfaces such as Serial Peripheral Interface (SPI), Inter-Integrated Circuit (I²C) or universal programmable serial interface module, Real Time Clock (RTC), timer-counters including interval and watchdog timers, general purpose Input-Output (IO), memory card controllers such as Secure Digital (SD)/ MultiMedia Card (MMC) or similar, Universal Serial Bus (USB) interfaces, Mobile Industry Processor Interface Alliance (MIPI) interfaces and Joint Test Access Group (JTAG) test access ports.

In some aspects, the baseband processor may be implemented, for example, as a solder-down substrate including one or more integrated circuits, a single packaged integrated circuit soldered to a main circuit board or a multi-chip module containing two or more integrated circuits.

In some aspects, the memory may include one or more of volatile memory including Dynamic Random Access Memory (DRAM) and/or Synchronous Dynamic Random Access Memory (SDRAM), and Non-Volatile Memory (NVM) including high-speed electrically erasable memory (commonly referred to as Flash memory), Phase change Random Access Memory (PRAM), Magnetoresistive Random Access Memory (MRAM) and/or a three-dimensional crosspoint (3D XPoint) memory. The memory may be implemented as one or more of solder down packaged integrated circuits, socketed memory modules and plug-in memory cards.

In some aspects, the power management (integrated) circuitry may include one or more of voltage regulators, surge protectors, power alarm detection circuitry and one or more backup power sources such as a battery or capacitor. Power alarm detection circuitry may detect one or more of brown out (under-voltage) and surge (over-voltage) conditions.

In some aspects, the power tee circuitry may provide for electrical power drawn from a network cable to provide both power supply and data connectivity to the base station using a single cable.

In some aspects, the network controller may provide connectivity to a network using a standard network interface protocol such as Ethernet. Network connectivity may be provided using a physical connection which is one of electrical (commonly referred to as copper interconnect), optical or wireless.

In some aspects, the satellite navigation receiver may include circuitry to receive and decode signals transmitted by one or more navigation satellite constellations such as the Global Positioning System (GPS), GLObalnaya NAvigatSionnaya Sputnikovaya Sistema (GLONASS), Galileo and/or BeiDou. The receiver may provide data to the application processor which may include one or more of position data or time data. The application processor may use time data to synchronize operations with other radio base stations.

In some aspects, the user interface may include one or more of physical or virtual buttons, such as a reset button, one or more indicators such as Light Emitting Diodes (LEDs) and a display screen.

Another example of an implementation using switch circuitry according to one or more aspects of the architecture described above in connection with Figs. 1 to 7 or one or more examples described above in connection with Figs. 1 to 7 is illustrated in Fig. 10. Fig. 10 schematically illustrates an example of a mobile device 1000 (e.g. mobile phone, smartphone, tablet-computer, or laptop) comprising a receiver 1010 as proposed.

The mobile device 1000 comprises at least one antenna element 1030 coupled to the receiver 1010. The receiver 1010 may be coupled to the antenna element 1030 via one or more intermediate element such as one or more of a signal line, a filter, etc.

The receiver 1010 comprises an attenuation circuit as proposed. For example, the receiver 1010 may be one of the receivers 600 and 700 described above. The receiver 1010 may comprise various further elements such as one or more of a LNA, a filter, a down-converter (mixer), ESD protection circuitry, etc.

Additionally, the mobile device 1000 comprises a transmitter 1020 configured to generate a RF transmit signal. The transmitter 1020 may use the antenna element 1030 or another antenna element (not illustrated) of the mobile device 1000 for radiating the RF transmit signal to the environment. For example, the transmitter 1020 may be coupled to the antenna element 1030 via one or more intermediate elements such as a filter, an up-converter (mixer) or a PA.

To this end, a mobile device with improved signal attenuation capabilities may be provided.

The mobile device 1000 may comprise further elements such as, e.g., an application processor, a baseband processor, memory, a connectivity module, a Near Field Communication (NFC) controller, an audio driver, a camera driver, a touch screen, a display driver, sensors, removable memory, a power management integrated circuit or a smart battery.

In some aspects, the application processor may include, for example, one or more CPU cores and one or more of cache memory, LDO regulators, interrupt controllers, serial interfaces such as SPI, I²C or universal programmable serial interface module, RTC, timer-counters including interval and watchdog timers, general purpose input-output (IO), memory card controllers such as SD/MMC or similar, USB interfaces, MIPI interfaces and JTAG test access ports.

In some aspects, the baseband processor may be implemented, for example, as a solder-down substrate including one or more integrated circuits, a single packaged integrated circuit soldered to a main circuit board, and/or a multi-chip module containing two or more integrated circuits.

The wireless communication circuits using switch circuitry or attenuation circuitry according to the proposed architecture or one or more of the examples described above may be configured to operate according to one of the 3rd Generation Partnership Project (3GPP)-standardized mobile communication networks or systems. The mobile or wireless communication system may correspond to, for example, a 5^{th} Generation New Radio (5G NR), a Long-Term Evolution (LTE), an LTE-Advanced (LTE-A), High Speed Packet Access (HSPA), a Universal Mobile Telecommunication System (UMTS) or a UMTS Terrestrial Radio Access Network (UTRAN), an evolved-UTRAN (e-UTRAN), a Global System for Mobile communication (GSM), an Enhanced Data rates for GSM Evolution (EDGE) network, or a GSM/EDGE Radio Access Network (GERAN). Alternatively, the wireless communication circuits may be configured to operate according to mobile communication networks with different standards, for example, a Worldwide Inter-operability for Microwave Access (WIMAX) network IEEE 802.16 or Wireless Local Area Network (WLAN) IEEE 802.11, generally an Orthogonal Frequency Division Multiple Access (OFDMA) network, a Time Division Multiple Access (TDMA) network, a Code Division Multiple Access (CDMA) network, a Wideband-CDMA (WCDMA) network, a Frequency Division Multiple Access (FDMA) network, a Spatial Division Multiple Access (SDMA) network, etc.

The examples described herein may be summarized as follows:
An example (e.g., example 1) relates to a switch circuit, comprising a first node for coupling to a first conductive path, a second node for coupling to a second conductive path, a first stack of transistors arranged between the first node and the second node, and a second stack of transistors arranged between the first node and the second node, wherein a first transistor of the first stack is cross-coupled with a second transistor of the second stack, wherein a first transistor of the second stack is cross-coupled with a second transistor of the first stack, the first transistors of the first and the second stack being coupled to the first node, wherein a third transistor of the first stack is cross-coupled with a fourth transistor of the second stack, wherein a third transistor of the second stack is cross-coupled with a fourth transistor of the first stack, the fourth transistors of the first and the second stack being coupled to the second node, wherein the second transistor of the first stack is coupled to the third transistor of the first stack, and wherein the second transistor of the second stack is coupled to the third transistor of the second stack.

Another example (e.g., example 2) relates to a previous example (e.g., example 1) or to any other example, further comprising that the first and the second transistor of the first stack and the third and the fourth transistor of the second stack are of a first conductivity type, wherein the first and the second transistor of the second stack and the third and the fourth transistor of the first stack are of a second conductivity type.

Another example (e.g., example 3) relates to a previous example (e.g., one of the examples 1 or 2) or to any other example, further comprising that a drain of the first transistor of the first stack is coupled to the first node, wherein a source of the second transistor of the first stack is coupled to a source of the third transistor of the first stack, wherein a drain of the fourth transistor of the first stack is coupled to the second node, wherein a drain of the first transistor of the second stack is coupled to the first node, wherein a source of the second transistor of the second stack is coupled to a source of the third transistor of the second stack, wherein a drain of the fourth transistor of the second stack is coupled to the second node, wherein a source of the first transistor of the first stack is coupled to a drain of the second transistor of the second stack, wherein a source of the first transistor of the second stack is coupled to a drain of the second transistor of the first stack, wherein a source of the fourth transistor of the first stack is coupled to a drain of the third transistor of the second stack, and wherein a source of the fourth transistor of the second stack is coupled to a drain of the third transistor of the first stack.

Another example (e.g., example 4) relates to a previous example (e.g., one of the examples 1 to 3) or to any other example, further comprising that a first conductive trace coupling the first transistor of the first stack and the second transistor of the second stack crosses a second conductive trace coupling the first transistor of the second stack and the second transistor of the first stack.

Another example (e.g., example 5) relates to a previous example (e.g., example 4) or to any other example, further comprising that a third conductive trace coupling the fourth transistor of the first stack and the third transistor of the second stack crosses a fourth conductive trace coupling the fourth transistor of the second stack and the third transistor of the first stack.

Another example (e.g., example 6) relates to a previous example (e.g., one of the examples 1 to 5) or to any other example, further comprising that the first stack and the second stack are arranged laterally offset from each other.

Another example (e.g., example 7) relates to a previous example (e.g., one of the examples 1 to 6) or to any other example, further comprising that a respective voltage clamp is coupled between sources of the first transistors of the first and the second stack, drains of the second transistors of the first and the second stack, drains of the third transistors of the first and the second stack and sources of the fourth transistors of the first and the second stack.

Another example (e.g., example 8) relates to a previous example (e.g., one of the examples 1 to 7) or to any other example, further comprising control circuitry configured to supply a respective control signal to a respective gate of the transistors of first and the second stack to control on- and off-state of the transistors.

Another example (e.g., example 9) relates to a previous example (e.g., example 8) or to any other example, further comprising that for electrically coupling the first node and the second node, the control circuitry is configured to adjust a respective signal level of the respective control signal to control the transistors of first and the second stack to be in the on-state.

Another example (e.g., example 10) relates to a previous example (e.g., one of the examples 8 or 9) or to any other example, further comprising that for electrically decoupling the first node from the second node, the control circuitry is configured to adjust a respective signal level of the respective control signal to control the transistors of first and the second stack to be in the off-state.

Another example (e.g., example 11) relates to a previous example (e.g., one of the examples 8 to 10) or to any other example, further comprising that a respective resistor is coupled between the respective gate of the transistors of first and the second stack and the control circuitry.

Another example (e.g., example 12) relates to a previous example (e.g., one of the examples 8 to 11) or to any other example, further comprising that the control circuitry comprises a plurality of voltage buffers coupled to the respective gate of either the transistors of a first conductivity type or the transistors of a second conductivity type in the first and the second stack, and a plurality of inverting voltage buffers coupled to the respective gate of the other of the transistors of the first conductivity type and the transistors of the second conductivity type, wherein the plurality of voltage buffers and the plurality of inverting voltage buffers are configured to receive a switch control signal and to generate the respective control signal for the respective transistor based on the switch control signal.

Another example (e.g., example 13) relates to a previous example (e.g., example 12) or to any other example, further comprising that the plurality of voltage buffers and the plurality of inverting voltage buffers are configured to receive a first supply voltage and a second supply voltage and generate the respective control signal with a voltage level between a voltage level of the first supply voltage and a voltage level of the second supply voltage.

Another example (e.g., example 14) relates to a previous example (e.g., one of the examples 8 to 11) or to any other example, further comprising a third node configured to receive a DC reference voltage, wherein the third node is resistively coupled between the second transistor of the first stack and the third transistor of the first stack and between the second transistor of the second stack and the third transistor of the second stack, and wherein the control circuitry comprises a first transistor of a second conductivity type, wherein a source of the first transistor is coupled to the third node, a second transistor of the second conductivity type, wherein a drain of the second transistor of the second conductivity type is coupled to a gate of the first transistor of the first stack, and wherein a gate of the second transistor of the second conductivity type is coupled to a drain of the first transistor of the second conductivity type, a first inverting voltage buffer configured to receive a first switch control signal at its input, wherein an output of the first inverting voltage buffer is coupled to a gate of the first transistor of the second conductivity type, and wherein the input of the first inverting voltage buffer is coupled to a source of the second transistor of the second conductivity type, a first transistor of a first conductivity type, wherein a source of the first transistor of the first conductivity type is coupled to the third node, a second transistor of the first conductivity type, wherein a drain of the second transistor of the first conductivity type is coupled to a gate of the first transistor of the second stack, and wherein a gate of the second transistor of the first conductivity type is coupled to a drain of the first transistor of the first conductivity type, a second inverting voltage buffer configured to receive a second switch control signal at its input, wherein an output of the second inverting voltage buffer is coupled to a gate of the first transistor of the first conductivity type, wherein the input of the second inverting voltage buffer is coupled to a source of the second transistor of the first conductivity type, and wherein the first and the second switch control signal are inverted with respect to each other.

Another example (e.g., example 15) relates to a previous example (e.g., one of the examples 1 to 14) or to any other example, further comprising that a respective capacitor is coupled between the respective gate and the respective source of the transistors of the first and the second stack.

Another example (e.g., example 16) relates to a previous example (e.g., one of the examples 1 to 15) or to any other example, further comprising that a respective capacitor is coupled between the respective gate and the respective drain of the transistors of the first and the second stack.

Another example (e.g., example 17) relates to a previous example (e.g., one of the examples 1 to 14) or to any other example, further comprising a third node configured to receive a DC reference voltage, wherein the third node is resistively coupled between the second transistor of the first stack and the third transistor of the first stack and between the second transistor of the second stack and the third transistor of the second stack.

Another example (e.g., example 18) relates to a previous example (e.g., one of the examples 1 to 17) or to any other example, further comprising that transistors of the first and the second stack are Gate-All-Around Field-Effect Transistors, GAAFETs, with nanosheets or Complementary Field-Effect Transistors, CFETs, with nanosheets.

An example (e.g., example 19) relates to an attenuation circuit, comprising a first signal path coupled between a first input node and a first output node, wherein the first signal path comprises a first plurality of resistive elements, a second signal path coupled between a second input node and a second output node, wherein the second signal path comprises a second plurality of resistive elements, and wherein the first input node and the second input node are configured to receive a respective one of a first input signal and a second input signal forming a differential input signal pair, and at least one shunt path coupled between the first signal path and the second signal path, wherein the at least one shunt path comprises at least one respective switch circuit according to a previous example (e.g., one of the examples 1 to 18) or to any other example to selectively couple the first signal path and the second signal path.

Another example (e.g., example 20) relates to a previous example (e.g., example 19) or to any other example, further comprising that the at least one respective switch circuit in the at least one shunt path is configured to selectively couple the first signal path and the second signal path based on at least one respective switch control signal.

An example (e.g., example 21) relates to a receiver comprising an attenuation circuit according to a previous example (e.g., one of the examples 19 and 20) or to any other example, a load coupled to the first output node and the second output of the attenuation circuit, and a control circuit configured to control coupling of the first signal path and the second signal path by the at least one respective switch circuit in the at least one shunt path based on a target attenuation of the first input signal and the second input signal.

Another example (e.g., example 22) relates to a previous example (e.g., example 21) or to any other example, further comprising that the first input signal and the second input signal are radio frequency signals.

Another example (e.g., example 23) relates to a previous example (e.g., one of the examples 21 or 22) or to any other example, further comprising that the load is one or more input buffers of an analog-to-digital converter.

An example (e.g., example 24) relates to a switch circuit, comprising a first node for coupling to a conductive path, a second node and a third node for coupling to ground or a supply voltage, a first stack of transistors arranged between the first node and the second node, and a second stack of transistors arranged between the first node and the third node, wherein a first transistor of the first stack is coupled to the first node, wherein a second transistor of the first stack is coupled to the second node, wherein a first transistor of the second stack is coupled to the first node, wherein a second transistor of the second stack is coupled to the third node, wherein the first transistor of the first stack is cross-coupled with the second transistor of the second stack, and wherein the first transistor of the second stack is cross-coupled with the second transistor of the first stack.

Another example (e.g., example 25) relates to a previous example (e.g., example 24) or to any other example, further comprising that the first and the second transistor of the first stack are of a first conductivity type, wherein the first and the second transistor of the second stack are of a second conductivity type.

Another example (e.g., example 26) relates to a previous example (e.g., one of the examples 24 or 25) or to any other example, further comprising that a drain of the first transistor of the first stack is coupled to the first node, wherein a source of the second transistor of the first stack is coupled to the second node, wherein a drain of the first transistor of the second stack is coupled to the first node, wherein a source of the second transistor of the second stack is coupled to the third node, wherein a source of the first transistor of the first stack is coupled to a drain of the second transistor of the second stack, wherein a source of the first transistor of the second stack is coupled to a drain of the second transistor of the first stack.

Another example (e.g., example 27) relates to a previous example (e.g., one of the examples 24 to 26) or to any other example, further comprising that a first conductive trace coupling the source of the first transistor of the first stack and the drain of the second transistor of the second stack crosses a second conductive trace coupling the source of the first transistor of the second stack and the drain of the second transistor of the first stack.

Another example (e.g., example 28) relates to a previous example (e.g., one of the examples 24 to 27) or to any other example, further comprising that the first stack and the second stack are arranged laterally offset from each other.

Another example (e.g., example 29) relates to a previous example (e.g., one of the examples 24 to 28) or to any other example, further comprising that a respective voltage clamp is coupled between sources of the first transistors of the first and the second stack and drains of the second transistors of the first and the second stack.

Another example (e.g., example 30) relates to a previous example (e.g., one of the examples 24 to 29) or to any other example, further comprising control circuitry configured to supply a respective control signal to a respective gate of the transistors of first and the second stack to control on- and off-state of the transistors.

Another example (e.g., example 31) relates to a previous example (e.g., example 30) or to any other example, further comprising that for electrically coupling the first node with the second and third node, the control circuitry is configured to adjust a respective signal level of the respective control signal to control the transistors of first and the second stack to be in the on-state.

Another example (e.g., example 32) relates to a previous example (e.g., one of the examples 30 or 31) or to any other example, further comprising that for electrically decoupling the first node from the second and third node, the control circuitry is configured to adjust a respective signal level of the respective control signal to control the transistors of first and the second stack to be in the off-state.

Another example (e.g., example 33) relates to a previous example (e.g., one of the examples 30 to 32) or to any other example, further comprising that a respective resistor is coupled between the respective gate of the transistors of first and the second stack and the control circuitry.

Another example (e.g., example 34) relates to a previous example (e.g., one of the examples 30 to 33) or to any other example, further comprising that the control circuitry comprises a plurality of voltage buffers coupled to the respective gate of either the transistors of the first stack or the transistors of the second stack, and a plurality of inverting voltage buffers coupled to the respective gate of the other of the transistors of the first stack and the transistors of the second stack, wherein the plurality of voltage buffers and the plurality of inverting voltage buffers are configured to receive a switch control signal and to generate the respective control signal for the respective transistor based on the switch control signal.

Another example (e.g., example 35) relates to a previous example (e.g., example 34) or to any other example, further comprising that the plurality of voltage buffers and the plurality of inverting voltage buffers are configured to receive a first supply voltage and a second supply voltage, and generate the respective control signal with a voltage level between a voltage level of the first supply voltage and a voltage level of the second supply voltage, wherein the second node and the third node are coupled to the second supply voltage.

Another example (e.g., example 36) relates to a previous example (e.g., one of the examples 30 to 33) or to any other example, further comprising a fourth node configured to receive a DC reference voltage, wherein the fourth node is resistively coupled between the second transistor of the first stack and the second node and between the second transistor of the second stack and the third node, and wherein the control circuitry comprises a first transistor of a second conductivity type, wherein a source of the first transistor is coupled to the fourth node, a second transistor of the second conductivity type, wherein a drain of the second transistor of the second conductivity type is coupled to a gate of the first transistor of the first stack, and wherein a gate of the second transistor of the second conductivity type is coupled to a drain of the first transistor of the second conductivity type, a first inverting voltage buffer configured to receive a first switch control signal at its input, wherein an output of the first inverting voltage buffer is coupled to a gate of the first transistor of the second conductivity type, and wherein the input of the first inverting voltage buffer is coupled to a source of the second transistor of the second conductivity type, a first transistor of a first conductivity type, wherein a source of the first transistor of the first conductivity type is coupled to the fourth node, a second transistor of the first conductivity type, wherein a drain of the second transistor of the first conductivity type is coupled to a gate of the first transistor of the second stack, and wherein a gate of the second transistor of the first conductivity type is coupled to a drain of the first transistor of the first conductivity type, a second inverting voltage buffer configured to receive a second switch control signal at its input, wherein an output of the second inverting voltage buffer is coupled to a gate of the first transistor of the first conductivity type, wherein the input of the second inverting voltage buffer is coupled to a source of the second transistor of the first conductivity type, and wherein the first and the second switch control signal are inverted with respect to each other.

Another example (e.g., example 37) relates to a previous example (e.g., one of the examples 26 to 36) or to any other example, further comprising that a respective capacitor is coupled between the respective gate and the respective source of the transistors of the first and the second stack.

Another example (e.g., example 38) relates to a previous example (e.g., one of the examples 26 to 37) or to any other example, further comprising that a respective capacitor is coupled between the respective gate and the respective drain of the transistors of the first and the second stack.

Another example (e.g., example 39) relates to a previous example (e.g., one of the examples 26 to 38) or to any other example, further comprising a fourth node configured to receive a DC reference voltage, wherein the fourth node is resistively coupled between the second transistor of the first stack and the second node and between the second transistor of the second stack and the third node.

Another example (e.g., example 40) relates to a previous example (e.g., one of the examples 26 to 39) or to any other example, further comprising that transistors of the first and the second stack are Gate-All-Around Field-Effect Transistors, GAAFETs, with nanosheets or Complementary Field-Effect Transistors, CFETs, with nanosheets.

An example (e.g., example 41) relates to an attenuation circuit, comprising a signal path coupled between an input node and an output node, wherein the first signal path comprises a first plurality of resistive elements, and wherein the input node is configured to receive an input signal, and at least one shunt path coupled between the shunt path and either ground or a supply voltage, wherein the at least one shunt path comprises at least one respective switch circuit according to any one of examples 26 to 40 to selectively couple the signal path with ground or the supply voltage.

Another example (e.g., example 42) relates to a previous example (e.g., example 41) or to any other example, further comprising that the at least one respective switch circuit in the at least one shunt path is configured to selectively couple the signal path with ground or the supply voltage based on at least one respective switch control signal.

An example (e.g., example 43) relates to a receiver comprising an attenuation circuit according to a previous example (e.g., one of the examples 41 and 42) or to any other example, a load coupled to the output node of the attenuation circuit, and a control circuit configured to control coupling of the signal path with ground or the supply voltage by the at least one respective switch circuit in the at least one shunt path based on a target attenuation of the input signal.

Another example (e.g., example 44) relates to a previous example (e.g., example 43) or to any other example, further comprising that the input signal is a radio frequency signal.

Another example (e.g., example 45) relates to a previous example (e.g., one of the examples 43 or 44) or to any other example, further comprising that the load is one or more input buffers of an analog-to-digital converter.

An example (e.g., example 46) relates to a base station, comprising a receiver according to a previous example (e.g., one of the examples 21 to 23 or 43 to 45), and a transmitter configured to generate a radio frequency transmit signal.

Another example (e.g., example 47) relates to a previous example (e.g., example 46) or to any other example, further comprising at least one antenna element coupled to at least one of the receiver and the transmitter.

An example (e.g., example 48) relates to a mobile device, comprising a receiver according to a previous example (e.g., one of the examples 21 to 23 or 43 to 45), and a transmitter configured to generate a radio frequency transmit signal.

Another example (e.g., example 49) relates to a previous example (e.g., example 48) or to any other example, further comprising at least one antenna element coupled to at least one of the receiver and the transmitter.

The aspects and features described in relation to a particular one of the previous examples may also be combined with one or more of the further examples to replace an identical or similar feature of that further example or to additionally introduce the features into the further example.

It is further understood that the disclosure of several steps, processes, operations or functions disclosed in the description or claims shall not be construed to imply that these operations are necessarily dependent on the order described, unless explicitly stated in the individual case or necessary for technical reasons. Therefore, the previous description does not limit the execution of several steps or functions to a certain order. Furthermore, in further examples, a single step, function, process or operation may include and/or be broken up into several substeps, -functions, -processes or -operations.

If some aspects have been described in relation to a device or system, these aspects should also be understood as a description of the corresponding method. For example, a block, device or functional aspect of the device or system may correspond to a feature, such as a method step, of the corresponding method. Accordingly, aspects described in relation to a method shall also be understood as a description of a corresponding block, a corresponding element, a property or a functional feature of a corresponding device or a corresponding system.

The following claims are hereby incorporated in the detailed description, wherein each claim may stand on its own as a separate example. It should also be noted that although in the claims a dependent claim refers to a particular combination with one or more other claims, other examples may also include a combination of the dependent claim with the subject matter of any other dependent or independent claim. Such combinations are hereby explicitly proposed, unless it is stated in the individual case that a particular combination is not intended. Furthermore, features of a claim should also be included for any other independent claim, even if that claim is not directly defined as dependent on that other independent claim.

## Claims

1. A switch circuit, comprising:
a first node for coupling to a first conductive path;
a second node for coupling to a second conductive path;
a first stack of transistors arranged between the first node and the second node; and
a second stack of transistors arranged between the first node and the second node,
wherein a first transistor of the first stack is cross-coupled with a second transistor of the second stack, wherein a first transistor of the second stack is cross-coupled with a second transistor of the first stack, the first transistors of the first and the second stack being coupled to the first node, wherein a third transistor of the first stack is cross-coupled with a fourth transistor of the second stack, wherein a third transistor of the second stack is cross-coupled with a fourth transistor of the first stack, the fourth transistors of the first and the second stack being coupled to the second node, wherein the second transistor of the first stack is coupled to the third transistor of the first stack, and wherein the second transistor of the second stack is coupled to the third transistor of the second stack.

2. The switch circuit of claim 1, wherein the first and the second transistor of the first stack and the third and the fourth transistor of the second stack are of a first conductivity type, and wherein the first and the second transistor of the second stack and the third and the fourth transistor of the first stack are of a second conductivity type.

3. The switch circuit of claim 1 or claim 2, wherein a drain of the first transistor of the first stack is coupled to the first node, wherein a source of the second transistor of the first stack is coupled to a source of the third transistor of the first stack, wherein a drain of the fourth transistor of the first stack is coupled to the second node, wherein a drain of the first transistor of the second stack is coupled to the first node, wherein a source of the second transistor of the second stack is coupled to a source of the third transistor of the second stack, wherein a drain of the fourth transistor of the second stack is coupled to the second node, wherein a source of the first transistor of the first stack is coupled to a drain of the second transistor of the second stack, wherein a source of the first transistor of the second stack is coupled to a drain of the second transistor of the first stack, wherein a source of the fourth transistor of the first stack is coupled to a drain of the third transistor of the second stack, and wherein a source of the fourth transistor of the second stack is coupled to a drain of the third transistor of the first stack.

4. The switch circuit of any one of claims 1 to 3, wherein a first conductive trace coupling the first transistor of the first stack and the second transistor of the second stack crosses a second conductive trace coupling the first transistor of the second stack and the second transistor of the first stack.

5. The switch circuit of claim 4, wherein a third conductive trace coupling the fourth transistor of the first stack and the third transistor of the second stack crosses a fourth conductive trace coupling the fourth transistor of the second stack and the third transistor of the first stack.

6. The switch circuit of any one of claims 1 to 5, wherein the first stack and the second stack are arranged laterally offset from each other.

7. The switch circuit of any one of claims 1 to 6, wherein a respective voltage clamp is coupled between sources of the first transistors of the first and the second stack, drains of the second transistors of the first and the second stack, drains of the third transistors of the first and the second stack and sources of the fourth transistors of the first and the second stack.

8. The switch circuit of any one of claims 1 to 7, further comprising control circuitry configured to supply a respective control signal to a respective gate of the transistors of first and the second stack to control on- and off-state of the transistors.

9. The switch circuit of claim 8, wherein a respective resistor is coupled between the respective gate of the transistors of first and the second stack and the control circuitry.

10. The switch circuit of claim 8 or claim 9, wherein the control circuitry comprises:
a plurality of voltage buffers coupled to the respective gate of either the transistors of a first conductivity type or the transistors of a second conductivity type in the first and the second stack; and
a plurality of inverting voltage buffers coupled to the respective gate of the other of the transistors of the first conductivity type and the transistors of the second conductivity type, wherein the plurality of voltage buffers and the plurality of inverting voltage buffers are configured to receive a switch control signal and to generate the respective control signal for the respective transistor based on the switch control signal.

11. The switch circuit of claim 10, wherein the plurality of voltage buffers and the plurality of inverting voltage buffers are configured to:
receive a first supply voltage and a second supply voltage; and
generate the respective control signal with a voltage level between a voltage level of the first supply voltage and a voltage level of the second supply voltage.

12. The switch circuit of claim 8 or claim 9, further comprising a third node configured to receive a DC reference voltage, wherein the third node is resistively coupled between the second transistor of the first stack and the third transistor of the first stack and between the second transistor of the second stack and the third transistor of the second stack, and wherein the control circuitry comprises:
a first transistor of a second conductivity type, wherein a source of the first transistor is coupled to the third node;
a second transistor of the second conductivity type, wherein a drain of the second transistor of the second conductivity type is coupled to a gate of the first transistor of the first stack, and wherein a gate of the second transistor of the second conductivity type is coupled to a drain of the first transistor of the second conductivity type;
a first inverting voltage buffer configured to receive a first switch control signal at its input, wherein an output of the first inverting voltage buffer is coupled to a gate of the first transistor of the second conductivity type, and wherein the input of the first inverting voltage buffer is coupled to a source of the second transistor of the second conductivity type;
a first transistor of a first conductivity type, wherein a source of the first transistor of the first conductivity type is coupled to the third node;
a second transistor of the first conductivity type, wherein a drain of the second transistor of the first conductivity type is coupled to a gate of the first transistor of the second stack, and wherein a gate of the second transistor of the first conductivity type is coupled to a drain of the first transistor of the first conductivity type;
a second inverting voltage buffer configured to receive a second switch control signal at its input, wherein an output of the second inverting voltage buffer is coupled to a gate of the first transistor of the first conductivity type, wherein the input of the second inverting voltage buffer is coupled to a source of the second transistor of the first conductivity type, and wherein the first and the second switch control signal are inverted with respect to each other.

13. The switch circuit of any one of claims 1 to 12, further comprising a third node configured to receive a DC reference voltage, wherein the third node is resistively coupled between the second transistor of the first stack and the third transistor of the first stack and between the second transistor of the second stack and the third transistor of the second stack.

14. The switch circuit of any one of claims 1 to 13, wherein transistors of the first and the second stack are Gate-All-Around Field-Effect Transistors, GAAFETs, with nanosheets or Complementary Field-Effect Transistors, CFETs, with nanosheets.

15. An attenuation circuit, comprising:
a first signal path coupled between a first input node and a first output node, wherein the first signal path comprises a first plurality of resistive elements;
a second signal path coupled between a second input node and a second output node, wherein the second signal path comprises a second plurality of resistive elements, and wherein the first input node and the second input node are configured to receive a respective one of a first input signal and a second input signal forming a differential input signal pair; and
at least one shunt path coupled between the first signal path and the second signal path, wherein the at least one shunt path comprises at least one respective switch circuit according to any one of claims 1 to 14 to selectively couple the first signal path and the second signal path.
